(19) Europäisches Patentamt
European Patent Office
Office européen des brevets

(11) EP 2 343 811 A1

(12) **DEMANDE DE BREVET EUROPEEN**

(43) Date de publication:
**13.07.2011 Bulletin 2011/28**

(51) Int Cl.:
***H03M 13/27** (2006.01)*

(21) Numéro de dépôt: **10016159.5**

(22) Date de dépôt: **29.12.2010**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**

(30) Priorité: **06.01.2010 FR 1000043**

(71) Demandeur: **STMicroelectronics (Grenoble 2) SAS**
**38000 Grenoble (FR)**

(72) Inventeur: **Paumier, Laurent**
**38000 Grenoble (FR)**

(74) Mandataire: **Marchand, André et al**
**OMNIPAT**
**24 Place des Martyrs de la Résistance**
**13100 Aix-en-Provence (FR)**

(54) **Procédé et dispositif d'entrelacement en ligne et en colonne pour blocs de taille variable**

(57) L'invention concerne un procédé d'entrelacement d'un flux de blocs de données d'entrée, le procédé comprenant des étapes consistant à : subdiviser un bloc (B) en sous-blocs (M11-Mnp) de taille fixe en nombre de lignes de données (NR) et de colonnes de données (NC), les sous-blocs étant répartis dans le bloc en lignes de sous-blocs (i) et en colonnes de sous-blocs (j), transférer les données du bloc dans une première mémoire (MEM1), en respectant l'ordre des données dans le flux d'entrée, transférer les données du bloc par ligne de sous-blocs, dans une seconde mémoire (MEM2) dans laquelle les données de chaque sous-bloc sont accessibles à partir de l'adresse du sous-bloc, transférer les données de chaque sous-bloc par colonne de sous-blocs, de la seconde mémoire dans une troisième mémoire (MEM3), en replaçant les données de chaque sous-bloc en lignes et en colonnes de données, et transférer les données par colonne de données de la troisième mémoire dans un flux de sortie (IB).

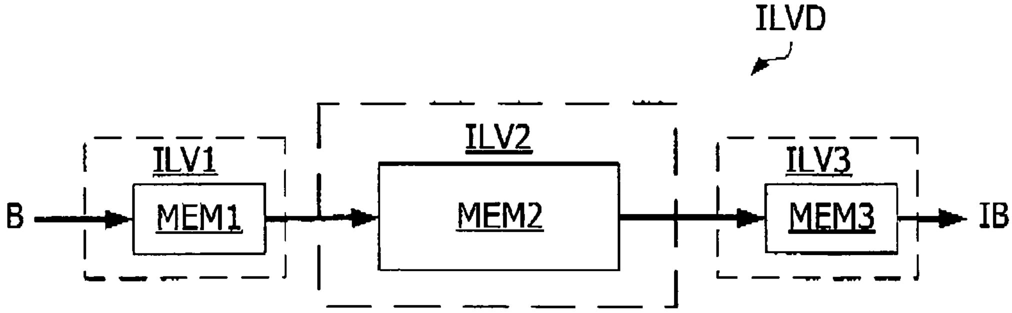


Fig. 2

EP 2 343 811 A1

## Description

La présente invention concerne l'entrelacement et le désentrelacement d'un flux de données. La présente invention s'applique notamment au standard DVB-T2 (Digital Video Broadcasting - Terrestrial 2).

Les systèmes de transmission numériques tels que le système DVB-T2 peuvent obtenir de bonnes performances, même en présence d'erreurs de transmission groupées, grâce à un récepteur réalisant en combinaison des opérations de correction d'erreur et de désentrelacement, l'opération de désentrelacement correspondant à une opération inverse d'entrelacement réalisée dans l'émetteur. L'opération de désentrelacement dans le récepteur permet de répartir d'une manière régulière dans un flux de données d'éventuelles erreurs de transmission groupées, et ainsi leur correction par un dispositif de correction d'erreur.

La figure 1 représente schématiquement un exemple de chaîne de transmission de blocs de données. Sur la figure 1, la chaîne de transmission COMC comprend un émetteur TRSM recevant un bloc de données à transmettre S, une liaison de transmission TC et un récepteur REC fournissant un bloc de données reçu S'. L'émetteur TRSM comprend classiquement un module de compression de données SENC recevant les blocs de données à transmettre S, un module d'encodage de canal CENC recevant les blocs de données compressés, un module d'entrelacement de données ILV recevant les blocs de données en sortie du module CENC et un modulateur MPM recevant les blocs de données entrelacées et les transmettant dans la liaison de transmission.

Le récepteur comprend un démodulateur DMP recevant les données transmises par la liaison TC, et fournissant des blocs de données démodulées, un module de désentrelacement DILV recevant les blocs de données démodulées, un module de décodage de canal CDEC recevant les blocs de données en sortie du module de désentrelacement et un module de décompression de données SDEC recevant les données décodées par le module CDEC et fournissant les blocs de données démodulées S'. Le module CDEC peut comprendre un module de correction d'erreur permettant d'exploiter des redondances dans le codage des données pour corriger d'éventuelles erreurs de transmission.

Il existe plusieurs procédés d'entrelacement, dont des procédés d'entrelacement par bloc, dans lesquels les données à entrelacer sont organisées sous la forme de blocs de plusieurs lignes et plusieurs colonnes. Un procédé d'entrelacement par bloc consiste par exemple à écrire les données consécutivement c'est-à-dire par ligne du bloc, dans une mémoire et à lire les données dans la mémoire par colonne du bloc, ou inversement. Si le procédé d'entrelacement effectue une lecture en ligne d'un bloc de données et une écriture en colonne, le procédé de désentrelacement correspondant effectue une lecture en colonne d'un bloc de données et une écriture en ligne, pour obtenir un bloc de données non entrelacées. Inversement, Si le procédé d'entrelacement effectue une lecture en colonne d'un bloc de données et une écriture en ligne, le procédé de désentrelacement correspondant effectue une lecture en ligne d'un bloc de données et une écriture en colonne. D'un point de vue fonctionnel, les opérations d'entrelacement et de désentrelacement sont donc équivalentes. Dans ce qui suit, le terme "entrelacement" désigne aussi bien une opération d'entrelacement qu'une opération de désentrelacement.

La latence d'une opération d'entrelacement par bloc est d'un bloc de données, c'est-à-dire que la première donnée d'un bloc de données est fournie en sortie du module d'entrelacement lorsque la totalité du bloc est reçue par le module. Dans certains systèmes comme ceux conformes au standard DVB-T2, la taille des blocs est variable. L'entrelacement des blocs peut être effectué en utilisant deux zones mémoire permettant de mémoriser deux blocs simultanément, l'un des deux blocs étant inscrit pendant que l'autre bloc est lu. Il est donc nécessaire de pouvoir disposer d'une mémoire ayant une capacité supérieure à la deux fois la taille maximum d'un bloc. Cette solution s'avère très onéreuse en terme de taille de mémoire nécessaire, lorsque la taille maximum d'un bloc est élevée. Conformément au standard DVB-T2, un bloc de données comprend 557 056 données de 32 bits. La mémoire utilisée par l'opération d'entrelacement doit donc présenter une taille d'au moins deux fois 17.8 Mbits.

Il est également possible d'utiliser une seule zone mémoire d'une capacité égale à la taille maximum d'un bloc et d'écrire les données d'un bloc au fur et à mesure que les données d'un autre bloc sont lues, aux emplacements déjà lus. Il est ainsi possible d'utiliser une mémoire à simple port ayant la taille d'un bloc de données, à condition qu'il ne soit pas nécessaire de lire et d'écrire durant un même cycle. En d'autres termes, la fréquence d'horloge cadençant la mémoire doit pouvoir être fixée à une valeur permettant au moins une lecture et une écriture de donnée dans la mémoire, durant la réception d'une donnée.

Cette solution est bien adaptée à des blocs de données de taille constante. Si les blocs de données sont de taille variable, il est nécessaire, pour éviter des conflits d'accès à la mémoire, de pouvoir lire les données d'un bloc plus rapidement que l'écriture d'un bloc suivant, avec la contrainte que le bloc en cours d'écriture suive immédiatement le bloc en cours de lecture. Par ailleurs, lorsque les blocs de données transmis sont de tailles variables, l'utilisation d'une unique zone mémoire ne permet pas de supporter toutes les combinaisons de changements de taille de bloc, en particulier lorsqu'un bloc de données est transmis à la suite d'un bloc de donnée de taille inférieure.

Il est donc souhaitable de réaliser un dispositif d'entrelacement par bloc, supportant une taille de bloc variable et nécessitant une capacité de mémoire réduite.

Un mode de réalisation concerne un procédé d'entrelacement d'un flux de données d'entrée réparties en blocs de données ayant chacun un nombre de lignes de données et un nombre de colonnes de données transversales aux lignes de données. Selon un mode de réalisation, le procédé comprend des étapes consistant à : subdiviser un bloc de données en sous-blocs ayant chacun un nombre fixe de lignes de données et un nombre fixe de colonnes de données, les sous-blocs étant répartis dans le bloc en lignes de sous-blocs et en colonnes de sous-blocs transversales aux lignes de sous-blocs, au moins le nombre de lignes ou de colonnes des sous-blocs étant supérieur à un, si le nombre de lignes dans un sous-bloc est supérieur à un, transférer les données du bloc dans une première mémoire, suivant un ordre dans lequel figurent les données dans le flux de données d'entrée, transférer les données du bloc, par ligne de sous-blocs, dans une seconde mémoire dans laquelle les données de chaque sous-bloc du bloc sont accessibles à partir d'une adresse du sous-bloc, si le nombre de colonnes dans un sous-bloc est supérieur à un, transférer les données de chaque sous-bloc par colonne de sous-blocs, de la seconde mémoire dans une troisième mémoire, en replaçant les données de chaque sous-bloc en lignes et en colonnes de données dans le sous-bloc, et transférer les données par colonne de données du bloc de données dans un flux de sortie, de la seconde mémoire si le nombre de colonnes de données dans un sous-bloc est égal à un, ou de la troisième mémoire si le nombre de colonnes de données dans un sous-bloc est supérieur à un.

Selon un mode de réalisation, le procédé comprend une étape de choix du nombre de lignes et/ou du nombre de colonnes d'un sous-bloc, de manière à ce que le nombre de lignes et/ou le nombre de colonnes d'un bloc de données soit un multiple, respectivement du nombre de lignes et du nombre de colonnes d'un sous-bloc.

Selon un mode de réalisation, les données de chaque sous-bloc dans la seconde mémoire sont accédées à partir d'un numéro d'index de sous-bloc mémorisé dans une quatrième mémoire.

Selon un mode de réalisation, le nombre de lignes et le nombre de colonnes d'un sous-bloc sont choisis de manière à limiter la taille totale des première, troisième et quatrième mémoires.

Selon un mode de réalisation, le procédé comprend une étape de transfert de données d'une ligne de sous-blocs d'un bloc suivant dans la seconde mémoire à des adresses occupées par des données d'une colonne de sous-blocs du bloc, transférées dans la troisième mémoire ou dans le flux de sortie.

Un mode de réalisation concerne également un dispositif d'entrelacement d'un flux de données d'entrée réparties en blocs de données ayant chacun un nombre de lignes de données et un nombre de colonnes de données transversales aux lignes de données. Selon un mode de réalisation, le dispositif est configuré pour mettre en oeuvre le procédé défini précédemment.

Selon un mode de réalisation, les blocs de données reçus sont divisés en sous-blocs ayant chacun un nombre fixe de lignes de données et un nombre fixe de colonnes de données, les sous-blocs étant répartis dans le bloc en lignes de sous-blocs et en colonnes de sous-blocs transversales aux lignes de sous-blocs, le dispositif comprenant une première mémoire prévue pour recevoir une ligne de sous-blocs d'un bloc de données.

Selon un mode de réalisation, la première mémoire présente une capacité limitée à la taille maximum d'une ligne de sous-blocs d'un bloc de données.

Selon un mode de réalisation, le dispositif est une seconde mémoire prévue pour recevoir un bloc de données.

Selon un mode de réalisation, la seconde mémoire présente une capacité limitée à la taille maximum d'un bloc de données.

Selon un mode de réalisation, le dispositif comprend une quatrième mémoire mémorisant des numéros d'index, chaque numéro d'index permettant d'accéder aux données d'un sous-bloc dans la seconde mémoire.

Selon un mode de réalisation, les blocs de données reçus sont divisés en sous-blocs ayant chacun un nombre fixe de lignes de données et un nombre fixe de colonnes de données, les sous-blocs étant répartis dans le bloc en lignes de sous-blocs et en colonnes de sous-blocs transversales aux lignes de sous-blocs, le dispositif comprenant une troisième mémoire prévue pour recevoir une colonne de sous-blocs d'un bloc de données.

Selon un mode de réalisation, la troisième mémoire présente une capacité limitée à la taille maximum d'une colonne de sous-blocs d'un bloc de données.

Un mode de réalisation concerne également un terminal de réception de signaux comprenant un dispositif d'entrelacement tel que défini précédemment.

Selon un mode de réalisation, les signaux sont conformes au standard DVB-T2.

Des exemples de réalisation de l'invention seront décrits dans ce qui suit, à titre non limitatif en relation avec les figures jointes parmi lesquelles :

- la figure 1 décrite précédemment, représente schématiquement une chaîne de transmission de données numériques,
- la figure 2 représente schématiquement un dispositif d'entrelacement, selon un mode de réalisation,
- la figure 3 représente schématiquement un premier module du dispositif d'entrelacement, selon un mode de réalisation,
- la figure 4 représente schématiquement un second module du dispositif d'entrelacement, selon un mode de réalisation,
- la figure 5 représente schématiquement un troisième module du dispositif d'entrelacement, selon un mode de réalisation,

- la figure 6 représente schématiquement le second module du dispositif d'entrelacement.

La figure 2 représente un dispositif d'entrelacement, selon un mode de réalisation. Sur la figure 2, le dispositif d'entrelacement ILVD comprend trois modules d'entrelacement ILV1, ILV2, ILV3. Le premier module ILV1 comprend une mémoire MEM1 recevant les données à entrelacer sous la forme de blocs de données B. Le second module ILV2 comprend une mémoire MEM2 recevant des données en sortie du module ILV1. Le troisième module ILV3 comprend une mémoire MEM3 recevant des données en sortie du module ILV2, et fournit des blocs de données entrelacés IB. Les blocs B peuvent présenter des nombres de lignes et de colonnes variables comme dans le standard DVB-T2. Les données sont réparties dans les blocs de données en lignes de données et en colonnes de données transversales aux lignes de données, le nombre de lignes et de colonnes de données peut varier d'un bloc à l'autre.

Selon un mode de réalisation, les blocs de données B en entrée du dispositif ILVD sont divisés en sous-blocs présentant des nombres de lignes et de colonnes de données fixes, les sous-blocs étant répartis en lignes de sous-blocs et en colonnes de sous-blocs transversales aux lignes de sous-blocs. La figure 3 représente le module ILV1 et une ligne i de sous-blocs Mi1, Mi2, ...Mip d'un bloc de données, dans la mémoire MEM1, lorsque celle-ci est écrite (à gauche sur la figure) et lorsque celle-ci est lue dans la mémoire (à droite sur la figure). Les sous-blocs Mi1-Mip présentent chacun des nombres de lignes NR et de colonnes NC fixes. Chaque ligne de données de la ligne i de sous-blocs comprend un nombre NCB de données pouvant être variable, correspondant au nombre de colonnes de données du bloc de données.

Selon un mode de réalisation, la mémoire MEM1 du module ILV1 présente une capacité correspondant à la taille maximale d'une ligne i de sous-blocs Mi1-Mip, à savoir NR fois le nombre maximum de colonnes d'un bloc de données B. Le module ILV1 reçoit successivement les données d'un bloc de données B et les insère dans la mémoire MEM1 à des adresses consécutives en commençant à une première adresse de la mémoire MEM1, comme indiqué par les flèches horizontales dans la ligne de sous-blocs i de gauche sur la figure 3. Une première donnée de chaque ligne de sous-blocs i est mémorisée à la première adresse de la mémoire MEM1. Lorsque la mémoire MEM1 a reçu toutes les données d'une ligne de sous-bloc i, le module ILV1 lit la mémoire MEM1 et transmet les données lues au module ILV2, de manière à ce que toutes les données de chacun des sous-blocs Mi1-Mip soient transmises consécutivement. A cet effet, le module ILV1 peut lire la mémoire MEM1 par colonne comme indiqué par les flèches verticales dans la ligne de sous-blocs i de droite sur la figure 3. La totalité des lignes de sous-blocs i d'un bloc de données B transite ainsi par la mémoire MEM1 et est transmise au module ILV2.

Il est à noter que si la mémoire MEM1 est accessible simultanément en écriture et en lecture (cas d'une mémoire à double port) ou si elle peut être accédée à la fois en écriture et en lecture au cours d'un même cycle de réception d'une donnée, la lecture de la mémoire MEM1 peut commencer lorsque la mémoire MEM1 contient au moins les données des NR-1 premières lignes de la ligne de sous-blocs i et une première donnée de la dernière ligne NR de la ligne de sous-blocs.

La figure 4 représente le module ILV2 et un bloc B dans la mémoire MEM2, lorsque celui-ci est écrit dans la mémoire (à gauche sur la figure) et lorsque celui-ci est lu dans la mémoire (à droite sur la figure). Les données des lignes de sous-blocs i d'un bloc B sont mémorisées dans la mémoire MEM2, avec une répartition correspondant à l'ordre dans lequel elles sont reçues par le module ILV2. Le bloc B mémorisé dans la mémoire MEM2 comprend ainsi des sous-blocs M11, M12, ... M1p, M21, M22, ... M2p, ... Mn1, Mn2, ... Mnp, chaque sous-bloc présentant une taille pouvant être fixe de NR lignes et NC colonnes. Le bloc de données B présente le nombre de colonnes NCB et un nombre de lignes NRB pouvant être variables. Le nombre de sous-blocs par ligne ou par colonne de sous-blocs peut donc être variable. La mémoire MEM2 du module ILV2 présente une capacité correspondant à au moins la taille maximale d'un bloc B. Lorsque le bloc B correspond à un premier bloc d'une séquence de blocs de données, celui-ci est écrit dans la mémoire MEM2 en remplissant successivement les sous-blocs M11-Mnp dans l'ordre croissant des adresses de ces dernières (suivant les flèches dans le bloc B de gauche sur la figure 4). Lorsque l'ensemble des données du bloc B se trouve dans la mémoire MEM2, les données du bloc B sont lues par colonne de sous-blocs M11-Mnp dans la mémoire MEM2 (suivant les flèches dans le bloc B de droite sur la figure 4), par exemple en respectant l'ordre dans lequel les données ont été mémorisées dans chaque sous-bloc. Les données lues sont transmises au module ILV3.

Il est à noter que si la mémoire MEM2 est accessible simultanément en écriture et en lecture ou si elle peut être accédée à la fois en écriture et en lecture au cours d'un même cycle de réception d'une donnée, la lecture de la mémoire MEM2 peut commencer lorsque celle-ci contient au moins les données d'une première colonne de sous-blocs M11 à Mn1.

La figure 5 représente le module ILV3 et une colonne j de sous-blocs M1j-Mnj dans la mémoire MEM3, lorsque celle-ci est écrite (à gauche sur la figure) et lorsque celle-ci est lue dans la mémoire (à droite sur la figure). La colonne j de sous-blocs M1j-Mnj présente un nombre de colonnes de données égal au nombre NC de colonnes dans un sous-bloc M11-Mnp, et un nombre de lignes égal au nombre de lignes NRB du bloc B. Selon un mode de réalisation, la mémoire MEM3 du module ILV3 présente une capacité correspondant à la taille maximale d'une colonne de sous-blocs M1j-Mnj, c'est-à-dire le nombre de colonnes NC fois le nombre maximum de lignes d'un bloc de données B. Le module ILV3 reçoit successivement les données de chacun des sous-blocs M11-Mnp d'une colonne de sous-blocs j dans le bloc de données B et les insère dans la mémoire MEM3 en commençant à une première adresse de la mémoire MEM3, comme indiqué sur la figure 5 par les flèches verticales dans la colonne de sous-blocs j de gauche. Les données sont transférées dans la mémoire MEM3 en restaurant la position en ligne et en colonne des données dans chaque sous-bloc, telle qu'elle figurait dans le bloc d'origine dans la mémoire MEM1.

Ainsi, une donnée de rang k dans la mémoire MEM1, k compris entre 0 et NCB x NR -1, est transférée vers la mémoire MEM2 à un rang k' obtenu par la formule suivante :

$$k' = \text{floor}(k / NCB) + \text{mod}(k,NCB) \times NR \qquad (1)$$

dans laquelle mod(a,b) est une fonction fournissant le reste de la division entière de a par b, et floor(a) est une fonction égale à la partie entière de a. mod(k,NCB) et floor(k / NCB) représentent donc les numéros de colonne et de ligne de la donnée de rang k.

D'autres formules peuvent être envisagées, dès lors que les données de chacun des sous-blocs sont fournies par la mémoire MEM1 de manière consécutive. Ainsi, le rang k' d'une donnée en sortie de la mémoire MEM1 peut être calculé à partir du rang k de la donnée dans le bloc reçu par le dispositif d'entrelacement ILVD, de la manière suivante :

$$k' = \text{mod}(\text{mod}(k,NCB),NC) + \text{floor}(\text{mod}(k,NCB) / NC) \times NM + \text{floor}(k / NCB) \times NC \qquad (2)$$

dans laquelle NM = NR x NC.

Une donnée introduite dans la mémoire MEM3 avec un rang k, k compris entre 0 et NRB x NC-1, est transférée dans le flux de sortie avec un rang k' qui peut être obtenu à l'aide de la formule suivante, si la formule (2) est utilisée pour lire la mémoire MEM1 :

$$k' = \text{floor}(k / NC) + \text{mod}(k,NC) \times NRB \qquad (3)$$

Si la formule (1) est utilisée pour lire la mémoire MEM1, une donnée de rang k peut être transférée de la mémoire MEM2 dans la mémoire MEM3 avec un rang k' obtenu à l'aide de la formule suivante :

$$k' = \text{floor}(\text{mod}(k,NR \times NC) / NR) \times NRB + \text{floor}(k / NM) \times NR + \text{mod}(\text{mod}(k,NM),NR) \qquad (4)$$

Lorsque la mémoire MEM3 a reçu toutes les données d'une colonne de sous-blocs j, le module ILV3 lit la mémoire MEM3 par colonne de données comme indiqué par les flèches verticales dans la colonne de sous-blocs j de droite sur la figure 5, chaque colonne de données comportant NRB données. La totalité des colonnes de sous-blocs M11-Mnp d'un bloc de données B transite ainsi par la mémoire MEM3 et est transmise en sortie du dispositif d'entrelacement ILVD sous la forme d'un bloc de données entrelacées IB dans lequel les données de chaque ligne du bloc B se trouvent réparties dans un même ordre sur une colonne de données et les données de chaque colonne du bloc B réparties dans un même ordre sur une ligne de données.

Dans un mode de réalisation, la mémoire MEM2 du module ILV2 présente une capacité correspondant exactement à la taille maximale d'un bloc B, et comprend des mémoires d'adressage permettant de réutiliser la mémoire MEM2 au fur et à mesure qu'elle est lue. A cet effet, le module ILV2 présente l'architecture représentée sur la figure 6. La figure 6 représente le module ILV2 selon un mode de réalisation. Le module ILV2 comprend un module d'adressage ADM permettant d'adresser en lecture ou en écriture la mémoire MEM2. La mémoire MEM2 comprend un port d'entrée de donnée 1 recevant des données DIN à mémoriser, et un port de sortie Q fournissant des données DOUT lues dans la mémoire. Le module ADM comprend deux mémoires d'adressage AMA, AMB comprenant chacune un port d'adresse A, un port de donnée d'entrée I et un port de donnée de sortie Q. Les ports d'adresse A des mémoires AMA, AMB sont connectées à la sortie d'un multiplexeur respectif MXA, MXB. Chaque multiplexeur MXA, MXB comprend des entrées d'adresse respectivement connectées à la sortie d'un générateur d'adresse incrémental ICWG, d'un générateur d'adresse incrémental ICRG, et d'un générateur d'adresse d'entrelacement ILAG. Le générateur ILAG reçoit les nombres de lignes et de colonnes NRB, NCB du bloc de données à traiter B.

La sortie de donnée Q de chaque mémoire d'adresse AMA, AMB est connectée à l'entrée I de l'autre mémoire d'adresse AMA, AMB et à une entrée respective d'un multiplexeur MX1. La sortie du multiplexeur MX1 fournit un numéro d'index Q d'un sous-bloc M11-Mnp à accéder dans la mémoire MEM2 à un module de calcul d'adresse ACM dont une sortie est connectée au port d'adresse A de la mémoire MEM2. Les générateurs ICWG, ICRG fournissent des adresses consécutives de lecture des mémoires AMA, AMB où sont stockés les index des sous-blocs M11-Mnp à accéder, respectivement en lecture et en écriture. Le générateur ILAG fournit des adresses d'écriture d'index de sous-blocs dans les mémoires AMA, AMB, les adresses fournies étant entrelacées. Le module ACM calcule une adresse de la mémoire MEM2 en fonction d'un numéro d'index de sous-bloc Q et du rang d'une donnée d'un bloc à lire ou à écrire dans la mémoire MEM2. La capacité de chacune des mémoires d'adresse AMA, AMB correspond au nombre maximum de sous-blocs de NM = NR x NC données, contenus dans un bloc de données B, soit NBmax/NM, NBmax étant le nombre maximum de données dans un bloc de données B. La capacité totale de mémoire nécessaire au module ILV2 (MEM2, AMA, AMB) peut donc être égale à NBmax (1 + 2 / NM) mots. Les index des sous-blocs peuvent être codés sous la forme de mots dont la taille dépend du nombre de sous-blocs dans un bloc de données. Si les données se présentent sous la forme de mots de 32 bits, et si les index des sous-blocs peuvent être codés sous la forme de mots de 16 bits, la capacité totale de mémoire du module ILV2 peut être réduite à NBmax (1 + 1 / NM) mots de 32 bits.

Les mémoires AMA et AMB sont par exemple initialisées par des numéros d'index croissants de sous-blocs M11-Mnp. Les mémoires AMA, AMB sont lues à chaque fois qu'un nouveau sous-bloc doit être accédé, soit toutes les NR x NC données. Durant le traitement d'un premier bloc, le générateur ICWG adresse la mémoire AMA de manière à mémoriser les données du bloc dans la mémoire MEM2, dans des sous-blocs M11-Mnp successifs. Parallèlement, les numéros d'index de sous-bloc fournis par la mémoire AMA sont transmis à la mémoire AMB pour y être mémorisés à des adresses entrelacées fournies par le générateur ILAG.

A la réception d'un second bloc par le module ILV2, la mémoire AMB est adressée d'une manière séquentielle par le module ICRG pour obtenir les numéros d'index entrelacés des sous-blocs M11-Mnp à accéder en lecture, où sont stockées les données du premier bloc dans la mémoire MEM2. Parallèlement (durant des périodes où la mémoire AMB n'est pas accédée en lecture), le module ICWG adresse d'une manière séquentielle la mémoire AMB pour obtenir les numéros d'index entrelacés des sous-blocs M11-Mnp à accéder en écriture, pour y écrire les données du second bloc dans la mémoire MEM2. Ainsi, les numéros d'index obtenus à partir des modules ICRG et ICWG sont les mêmes de manière à écrire les données du second bloc aux emplacements lus dans la mémoire MEM2, le module ICRG étant en avance sur le module ICWG pour assurer qu'une adresse de la mémoire MEM2, où se trouve une donnée soit toujours lue avant d'être écrite. Les numéros d'index lus dans la mémoire AMB par exemple par le module ICWG sont transférés dans la mémoire AMA à des adresses entrelacées générées par le générateur ILAG. A la réception d'un troisième bloc par le module ILV2, le second bloc est lu dans les sous-blocs M11-Mnp ayant des numéros d'index lus séquentiellement dans la mémoire AMA, et les données du troisième bloc sont transférées dans les sous-blocs lus. Parallèlement, les numéros d'index lus dans la mémoire AMA sont transférés dans la mémoire AMB à des adresses entrelacées générées par le module ILAG. Ce traitement est ainsi répété pour tous les blocs de données d'une séquence de blocs.

Il est à noter que la prévision des deux modules de génération d'adresse incrémentale de lecture ICRG et d'écriture ICWG permet de rendre indépendantes la lecture et l'écriture d'une donnée dans la mémoire MEM2, et en particulier de ne pas subordonner la lecture d'une donnée dans la mémoire MEM2 à la réception d'une donnée de même rang à écrire dans cette mémoire. Bien entendu, il ne peut être prévu qu'un seul module génération d'adresse incrémentale de lecture. Dans ce cas, chaque lecture d'une donnée à une adresse de la mémoire MEM2 doit être suivie d'une écriture d'une donnée à cette adresse, avant qu'une autre adresse de la mémoire MEM2 soit lue.

Pour expliquer le fonctionnement du module ADM, prenons l'exemple d'une séquence de deux blocs de données successifs B1 de taille NRB1 x NCB1 = N1 et B2 de taille NRB2 x NCB2 = N2. Le bloc B est divisé en sous-blocs numérotés de M11 à Mn1p1, et le bloc B2 est divisé en sous-blocs numérotés de M11 à Mn2p2. L'adresse A d'une donnée de rang k d'un bloc à lire ou à écrire est calculée par le module de calcul d'adresse ACM de la manière suivante :

$$A = NM \times Q + \mathrm{mod}(k,NM) \qquad (5)$$

Dans cette formule, NM (= NR x NC) est le nombre de données dans chaque sous-bloc M11-Mnp, Q est le numéro d'index de sous-bloc lu dans la mémoire AMA ou AMB et se trouvant en sortie du multiplexeur MX1, k est le rang de la donnée dans le bloc B (compris entre 0 et NRB x NCB - 1) tel que ce dernier est mémorisé dans la mémoire MEM2. La fonction mod(k,NM) fournit donc la position de la donnée de rang k dans un sous-bloc mémorisé dans la mémoire MEM2.

Durant une première étape de réception du bloc B1 par le module ILV2, les données du bloc B1 sont mémorisées séquentiellement dans la mémoire MEM2 à des adresses consécutives déterminées à partir de numéros d'index consécutifs fournis par la mémoire AMA, en raison du fait que la mémoire AMA est initialisée avec des numéros d'index consécutifs et lue d'une manière séquentielle. Les numéros d'index lus dans la mémoire AMA sont transférés dans la mémoire AMB à des adresses entrelacées générées par le module ILAG.

Durant une seconde étape de lecture du premier bloc B1, la mémoire AMB est adressée séquentiellement par le module ICRG pour obtenir les numéros d'index des sous-blocs M11-Mn1p1 à lire. Ainsi, à la lecture d'une donnée de rang k du bloc B1, la mémoire AMB est lue si mod(k,NM) = 0, à une adresse égale à floor(k/NM) fournie par le module ICRG. Le numéro d'index lu Q dans la mémoire AMB est fourni au module ACM qui calcule en appliquant la formule (5) l'adresse de la mémoire MEM2 à utiliser pour y lire une donnée du bloc B1. Si la condition mod(k,NM) = 0 n'est pas satisfaite, le numéro d'index Q précédemment lu dans la mémoire AMB est utilisé par le module ACM pour calculer l'adresse de lecture de la mémoire MEM2 à l'aide de la formule (5).

L'écriture d'une donnée du bloc B2 dans la mémoire MEM2 est effectuée à l'adresse d'une donnée du bloc B1 qui vient d'être lue. Cette écriture est effectuée de la même manière que la lecture d'une donnée du bloc B1 dans la mémoire MEM2, à la différence que l'adresse de lecture de la mémoire AMB est fournie par le module ICWG. Durant l'écriture d'une donnée dans la mémoire MEM2, la mémoire AMA reçoit les numéros d'index Q lus dans la mémoire AMB et les mémorise à des adresses entrelacées AA générées par le module ILAG, en appliquant la formule suivante :

$$\begin{aligned}&\text{Si floor}(k / NM) \neq N2 / NM - 1,\\&\qquad AA = \text{mod}(\text{floor}(k / NM) \times (NRB2 / NR), N2 / NM - 1)\\&\text{Sinon } AA = N2 / NM - 1\end{aligned} \qquad (6)$$

La mémoire MEM2 est accédée en lecture jusqu'à ce que la totalité du bloc B1 ait été transférée en sortie du module ILV2, et en écriture, jusqu'à ce que la totalité du bloc B2 ait été mémorisée dans la mémoire MEM2. Si la taille N2 du bloc B2 est inférieure à la taille N1 du bloc B1, les index de sous-bloc qui n'ont pas été lus dans la mémoire AMB sont ensuite transférés dans la mémoire AMA à des adresses consécutives. Ainsi, l'adresse de lecture de la mémoire AMB est égale à l'adresse d'écriture de la mémoire AMA (transfert non entrelacé des numéros d'index de la mémoire AMB vers la mémoire AMA) lorsque l'index de sous-bloc du bloc B1 est compris entre N2/NM et N1/NM - 1. Cette opération est effectuée pour des blocs ultérieurs qui auraient une taille supérieure à N2.

A chacune des étapes suivantes de réception d'un nouveau bloc de donnée et de lecture du bloc précédent, les opérations effectuées durant la seconde étape sont exécutées en inversant les rôles des mémoires AMA et AMB par rapport à l'étape précédente.

La description qui précède des étapes de réception de blocs de données est applicable lorsque le rapport du nombre de colonnes d'un bloc NCB sur le nombre de colonnes d'un sous-bloc NC et le rapport du nombre de lignes d'un bloc NRB sur le nombre de lignes d'un sous-bloc NR sont des nombres entiers.

Lorsque les rapports NCB/NC et NRB/NR d'un bloc de NCB x NRB données ne sont pas des nombres entiers, le module ACM calcule l'adresse RA d'une donnée de rang k dans le bloc de données, à lire dans la mémoire MEM2, en fonction du numéro d'index de sous-bloc Q, de la manière suivante :

$$\begin{aligned}&\text{Si } 0 \leq k < NDC \times NRB,\\&\qquad RA = NM \times Q + \text{mod}(\text{mod}(k, NC \times NRB), NM),\\&\text{Sinon si } NDC \times NRB \leq k < NRB \times NCB,\\&\qquad RA = NM \times Q + \text{mod}[k - NDC \times NRB, (NCB - NDC) \times NR]\end{aligned} \qquad (7)$$

avec NDC = floor(NCB/NC) x NC

De même pour calculer l'adresse d'écriture WA d'une donnée de rang k d'un bloc dans la mémoire MEM2, le module ACM applique la formule suivante :

$$
\begin{aligned}
&\text{Si } 0 \le k < NDR \times NCB, \\
&\quad WA = NM \times Q + mod(mod(k, NR \times NCB), NM), \\
&\text{Sinon si } NDR \times NCB \le k < NRB \times NCB, \\
&\quad WA = NM \times Q + mod[k - NDR \times NCB, (NRB - NDR) \times NC] \qquad (8)
\end{aligned}
$$

avec NDR = floor(NRB/NR) x NR

Durant une première étape d'écriture du premier bloc B1 de taille NRB1 lignes et NCB1 colonnes, dans la mémoire MEM2, la mémoire AMA est accédée séquentiellement et fournit des numéros d'index de sous-bloc consécutifs, et le module ACM applique la formule (8) pour déterminer l'adresse d'écriture de chaque donnée du bloc B1.

Durant une seconde étape de lecture du bloc B1 dans la mémoire MEM2, la mémoire AMB est lue lorsque la condition suivante est réalisée :

$$
\begin{aligned}
&k < NDC1 \times NRB1 \text{ et } mod(mod(k, NRB1 \times NC), NM) = 0 \text{ ou} \\
&k \ge NDC1 \times NRB1 \text{ et } mod(k - NDC1 \times NRB1, (NCB1 - NDC1) \times NR) = 0 \qquad (9) \\
&\text{avec } NDC1 = floor(NCB1 / NC) \times NC
\end{aligned}
$$

L'adresse de lecture RA de la mémoire AMB peut être déterminée en fonction du rang k de la donnée du bloc B1 à lire dans la mémoire MEM2, de la manière suivante :

$$
\begin{aligned}
&\text{si } k < NDC1 \times NRB1 \\
&\quad RA = ceil(NRB1 / NR) \times floor(k / (NC \times NRB1)) + \\
&\qquad floor(mod(k, NC \times NRB1) / NM) \\
&\text{sinon } RA = floor(NCB1 / NC) * ceil(NRB1 / NR) + \\
&\qquad floor[(k - NDC1 \times NRB1) / ((NCB1 - NDC1) \times NR)] \qquad (10)
\end{aligned}
$$

dans laquelle la fonction cell(a) = floor(a) + 1 si a n'est pas un nombre entier et ceil(a) = floor(a) si a est un nombre entier.

Le numéro d'index Q lu dans la mémoire AMB à l'adresse RA est utilisé par le module ACM pour calculer l'adresse de lecture de la donnée du bloc B1 dans la mémoire MEM2.

S'il s'agit d'une donnée du bloc B2 à écrire, l'adresse de lecture RA de la mémoire AMB peut être déterminée en fonction du rang k de la donnée à écrire du bloc B2 de taille NRB2 lignes et NCB2 colonnes, de la manière suivante :

$$
\begin{aligned}
&\text{Si } k < NDR2 \times NCB2 \\
&\quad RA = ceil(NCB2 / NC) \times floor(k / (NR \times NCB2)) + \\
&\qquad floor(mod(k, NR \times NCB2) / NM) \\
&\text{Sinon } RA = floor(NRB2 / NR) \times ceil(NCB2 / NC) + \\
&\qquad floor((k - NDR2 \times NCB2) / ((NRB2 - NDR2) \times NC)) \qquad (11)
\end{aligned}
$$

avec NDC2 = floor(NCB2 / NC) x NC et NDR2 = floor(NRB2 / NR) x NR.

Le numéro d'index Q lu dans la mémoire AMB à l'adresse RA est utilisé par le module ACM pour calculer l'adresse d'écriture de la donnée de rang k du bloc B2 dans la mémoire MEM2.

Le module ILAG calcule l'adresse d'écriture WA dans la mémoire AMA du numéro d'index Q lu dans la mémoire AMB de la manière suivante :

$$\text{Si } RA \neq \text{ceil}(NCB2 / NC) \times \text{ceil}(NRB2 / NR) - 1,$$
$$WA = \text{mod}(RA \times \text{ceil}(NRB2 / NR), \text{ceil}(NCB2 / NC) \times \text{ceil}(NRB2 / NR) - 1)$$
$$\text{Sinon}$$
$$WA = \text{ceil}(NCB2 / NC) \times \text{ceil}(NRB2 / NR) - 1 \quad (12)$$

Par ailleurs, il peut être nécessaire de transférer les numéros d'index non lus dans la mémoire AMB, vers la mémoire AMA durant des cycles d'attente. Ce transfert est effectué si la condition suivante est réalisée :

$$\text{ceil}(NCB2/NC) \times \text{ceil}(NRB2 / NR) < \text{ceil}(NCB1 / NC) \times \text{ceil}(NRB1 / NR) \quad (13)$$

Ce transfert est effectué en lisant de manière incrémentale la mémoire AMB et en transférant la valeur lue à la même adresse dans la mémoire AMA pour toutes les valeurs d'adresse comprises entre ceil(NCB2/NC) x ceil (NRB2/NR) et ceil(NCB1 / NC) x ceil(NRB1/NR) - 1.

A chacune des étapes suivantes de réception d'un nouveau bloc de donnée et de lecture du bloc précédent, les opérations effectuées durant la seconde étape sont exécutées en inversant les rôles des mémoires AMA et AMB par rapport à l'étape précédente.

L'annexe 1 indique à titre d'exemple l'ordre d'arrivée de données d'un bloc dans les mémoires MEM1, MEM2 et MEM3 à certaines des étapes 1 à 11 de traitement d'entrelacement du bloc. Dans l'exemple de l'annexe 1, le bloc B comprend des données D(1,1)-D(10,12) réparties en 12 colonnes et 10 lignes Les données sont indiquées dans l'annexe 1 dans un ordre correspondant à une lecture par ligne de gauche à droite, puis par colonne de haut en bas. L'annexe 1 illustre le cas où le nombre de colonnes d'un sous-bloc NC est choisi égal à 3 et le nombre de lignes d'un sous-bloc NR égal à 2. La mémoire MEM1 est donc dimensionnée pour recevoir deux lignes de 12 données d'un bloc B, et la mémoire MEM3 trois colonnes de 10 données du bloc B.

A l'étape 1, les données des NR = 2 premières lignes D(1,1)-D(1,12) et D(2,1)-D(2,12) d'un bloc sont reçues par le dispositif d'entrelacement et transférées dans la mémoire MEM1 du module ILV1. A l'étape 2, les données dans la mémoire MEM1 sont transférées dans la mémoire MEM2 du module ILV2, et les données des deux lignes suivantes du bloc D(3,1)-D(3,12) et D(4,1)-D(4,12) du bloc sont reçues par le dispositif d'entrelacement et transférées dans la mémoire MEM1. Le transfert de données dans la mémoire MEM2 est effectué de manière à ce que les données de chaque sous-bloc se trouvent à des adresses consécutives dans la mémoire MEM2. A l'étape 3, les données dans la mémoire MEM1 sont transférées dans la mémoire MEM2, et les données des deux lignes suivantes D(5,1)-D(5,12) et D(6,1)-D(6,12) du bloc sont reçues par le dispositif d'entrelacement et transférées dans la mémoire MEM1. A l'étape 5, les données dans la mémoire MEM1 sont transférées dans la mémoire MEM2 et les données des deux dernières lignes D(9,1)-D(9,12) et D(10,1)-D(10,12) du bloc sont reçues par le dispositif d'entrelacement et transférées dans la mémoire MEM1. A l'étape 6, les données dans la mémoire MEM1 sont transférées dans la mémoire MEM2. La mémoire MEM2 contient alors toutes les données du bloc D(1,1)-D(10,12). A l'étape 7, les données D(1,1)-D(10,1), D(1,2)-D(10,2), D (1,3)-D(10,3) des NC = 3 premières colonnes de la mémoire MEM2 sont transférées dans la mémoire MEM3 du module ILV3. A l'étape 8, les données dans la mémoire MEM3 sont lues colonne de données par colonne de données et transférées dans un flux de sortie, et les données des trois colonnes suivantes D(1,4)-D(10,6) du bloc dans la mémoire MEM2 sont transférées dans la mémoire MEM3 en remplacement des données transférées dans le flux de sortie. A l'étape 10, les données dans la mémoire MEM3 sont lues colonne de données par colonne de données et transférées dans le flux de sortie, et les données des trois dernières colonnes D(1,10)-D(10,10), D(1,11)-D(10,11), D(1,12)-D(10,12) du bloc se trouvant dans la mémoire MEM2 sont transférées dans la mémoire MEM3 en remplacement des données transférées dans le flux de sortie. A l'étape 11 et dernière étape de traitement du bloc, les données dans la mémoire MEM3 sont transférées dans le flux de sortie. Le flux de sortie contient ainsi toutes les lignes de données du bloc en entrée du dispositif d'entrelacement, dans lequel les données dans les colonnes de données du bloc en entrée du dispositif ILVD apparaissent consécutivement dans le flux de sortie.

A l'étape 6 et aux suivantes, la mémoire MEM1 peut recevoir deux par deux les lignes de données d'un bloc suivant. A partir de l'étape 7, les données du bloc suivant dans la mémoire MEM1 peuvent être transférées dans la mémoire MEM2 aux emplacements laissés libres par les données transférées dans la mémoire MEM3. Il en résulte que les données du bloc sont écrites par colonnes dans la mémoire MEM2. Les adresses où sont stockées les données du bloc suivant sont mémorisées dans l'une des mémoires AMA, AMB.

La mémoire MEM3 pourrait également être remplie par ligne comme illustré dans l'exemple de l'annexe 2 indiquant l'état des mémoires MEM1, MEM2, MEM3 à partir de l'étape 7 où la mémoire MEM3 commence à être utilisée. Dans cet exemple, aux étapes 7 à 10, une colonne de sous-blocs provenant de la mémoire MEM2 est transférée dans la mémoire MEM3 en ligne de sous-blocs, les données de chaque sous-bloc étant transférées dans la mémoire MEM3 en inversant les lignes et les colonnes de données du sous-bloc. Aux étapes 8 à 11, à la différence de l'exemple de l'annexe 1, la mémoire MEM3 est lue ligne de données par ligne de données, les données lues étant transférées dans le flux de sortie.

Dans l'exemple de l'annexe 2, une donnée de rang k, k étant compris entre 0 et NRB x NC -1, lue dans une colonne de sous-blocs de la mémoire MEM2, est transférée dans la mémoire MEM3 à une adresse k' obtenue à l'aide de la formule (4). Les données dans la mémoire MEM3 peuvent ensuite être transférées dans le flux de sortie en lisant consécutivement les adresses où elles sont mémorisées.

D'une manière générale, il existe de multiples possibilités de rangement des données dans les mémoires MEM1, MEM3, compte tenu des contraintes exposées précédemment. Il suffit que les adresses de lecture des données dans une mémoire soient cohérentes avec les adresses d'écriture de ces données dans cette mémoire.

Conformément au standard DVB-T2, la taille d'un bloc de données peut présenter les valeurs résumées dans le tableau 1 suivant :

Tableau 1

| Mode | NRB | NCB (multiple de 5) | NBmax |
|---|---|---|---|
| Trame longue 256-QAM | 1620 | de5à 340 | 550800 |
| Trame longue 64-QAM | 2160 | de 5 à 255 | 550800 |
| Trame longue 16-QAM | 3240 | de 5 à 170 | 550800 |
| Trame longue QPSK | 6480 | de 5 à 85 | 550800 |
| Trame courte 256-QAM | 405 | de 5 à 1375 | 556875 |
| Trame courte 64-QAM | 540 | de 5 à 1030 | 556200 |
| Trame courte 16-QAM | 810 | de 5 à 685 | 554850 |
| Trame courte QPSK | 1620 | de 5 à 340 | 550800 |

Compte tenu des tailles possibles de bloc résumés dans le tableau 1, si l'on choisit une taille de sous-bloc telle que les rapports NRB/NR et NCB/NC soient entiers, le nombre NC peut être choisi égal à 1 ou 5, et le nombre NR peut être choisi égal à l'une des valeurs 1, 3, 5, 9, 15, 45 et 135. Si le nombre NR ou NC est choisi égal à 1, le dispositif d'entrelacement ILVD ne comporte alors pas de module ILV1 ou ILV3, respectivement. Le cas où les nombres NR et NC sont tous deux égaux à 1 est écarté car il correspond à un dispositif d'entrelacement conforme à l'art antérieur, c'est-à-dire ne comportant que le module d'entrelacement ILV2, et sans subdivision du bloc en sous-blocs de taille fixe.

Compte tenu des valeurs indiquées dans le tableau 1, le tableau 2 qui suit résume les capacités nécessaires des mémoires MEM1, MEM3, AMA, AMB, sachant que la mémoire MEM1 présente une capacité de 17 Mbits pour pouvoir mémoriser un bloc de 556875 données de 32 bits.

Tableau 2

| NC | NR | Capacité de (en Mbits) : | | | |
|---|---|---|---|---|---|
| | | MEM1 | MEM3 | AMA+AMB | Total |
| 1 | 3 | 0.26 | 0 | 6.68 | 6.94 |
| | 5 | 0.44 | 0 | 3.79 | 4.23 |
| | 9 | 0.79 | 0 | 1.98 | 2.77 |
| | 15 | 1.32 | 0 | 1.19 | 2.51 |
| | 45 | 3.96 | 0 | 0.35 | 4.31 |
| | 135 | 11.88 | 0 | 0.11 | 11.99 |

(suite)

| NC | NR | Capacité de (en Mbits) : | | | |
|---|---|---|---|---|---|
| | | MEM1 | MEM3 | AMA+AMB | Total |
| 5 | 1 | 0 | 2.07 | 3.79 | 3.79 |
| | 3 | 0.26 | 2.07 | 1.19 | 3.52 |
| | 5 | 0.44 | 2.07 | 0.67 | 3.18 |
| | 9 | 0.79 | 2.07 | 0.34 | 3.2 |
| | 15 | 1.32 | 2.07 | 0.19 | 3.58 |
| | 45 | 3.96 | 2.07 | 0.06 | 6.09 |
| | 135 | 11.88 | 2.07 | 0.02 | 13.97 |

Il apparaît dans le tableau une valeur de capacité totale minimum de 2.51 Mbits atteinte lors que NC = 1 et NR = 15, et une valeur de capacité totale minimum de 3.18 Mbits atteinte lorsque les nombres NC et NR sont égaux à 5. La capacité requise pour le dispositif ILVD peut donc être inférieure à la capacité de la mémoire requise pour un dispositif d'entrelacement de l'art antérieur qui soit capable de traiter des blocs de données de taille variable, c'est-à-dire égale à deux fois la taille maximum d'un bloc conforme au standard DVB-T2.

Dans certains cas, les modules ILV1 et ILV3 peuvent utiliser des mémoires qui sont nécessaires pour des traitements antérieurs ou postérieurs au traitement d'entrelacement. Dans le standard DVB-T2, l'entrelacement réalisé par le module ILV3 peut être réalisé à la volée dans un module de désentrelacement par cellule prévu en sortie du dispositif ILVD. Il en résulte que la capacité de mémoire nécessaire au module ILV3 indiquée dans le tableau 2 peut être supprimée, de sorte que seulement 1.11 Mbits doivent être ajoutés à la capacité de la mémoire MEM2 pour réaliser le module ILVD, si les nombres NR et NC sont tous deux choisis égaux à 5.

Il apparaîtra clairement à l'homme de l'art que la présente invention est susceptible de diverses variantes de réalisation et diverses applications. En particulier, l'invention n'est pas limitée à des flux de données conformes au standard DVB-T2 mais s'applique à tout flux de données comportant des blocs de données rassemblant des données disposées en lignes et en colonnes.

Par ailleurs, l'invention n'est pas limitée à au module d'entrelacement ILV2 représenté sur la figure 6. D'autres modes de réalisation du module ILV2 peuvent être envisagées sans sortir du cadre de la présente invention. Ainsi, par exemple les mémoires AMA et AMB peuvent être supprimées et remplacées par des circuits de calcul de numéros d'index de sous-blocs à accéder en écriture ou en lecture.

# Annexe 1

Etape 1

MEM1

| | | | | | | | | | | | |
|---|---|---|---|---|---|---|---|---|---|---|---|
| D(1,1) | D(1,2) | D(1,3) | D(1,4) | D(1,5) | D(1,6) | D(1,7) | D(1,8) | D(1,9) | D(1,10) | D(1,11) | D(1,12) |
| D(2,1) | D(2,2) | D(2,3) | D(2,4) | D(2,5) | D(2,6) | D(2,7) | D(2,8) | D(2,9) | D(2,10) | D(2,11) | D(2,12) |

MEM2

| | | | |
|---|---|---|---|
| | | | |
| | | | |
| | | | |
| | | | |
| | | | |

MEM3

| | | |
|---|---|---|
| | | |
| | | |
| | | |
| | | |
| | | |
| | | |
| | | |
| | | |
| | | |

Sortie

Etape 2

MEM1

| | | | | | | | | | | | |
|---|---|---|---|---|---|---|---|---|---|---|---|
| D(3,1) | D(3,2) | D(3,3) | D(3,4) | D(3,5) | D(3,6) | D(3,7) | D(3,8) | D(3,9) | D(3,10) | D(3,11) | D(3,12) |
| D(4,1) | D(4,2) | D(4,3) | D(4,4) | D(4,5) | D(4,6) | D(4,7) | D(4,8) | D(4,9) | D(4,10) | D(4,11) | D(4,12) |

MEM2

| | | | |
|---|---|---|---|
| D(1,1) D(2,1) D(1,2) D(2,2) D(1,3) D(2,3) | D(1,4) D(2,4) D(1,5) D(2,5) D(1,6) D(2,6) | D(1,7) D(2,7) D(1,8) D(2,8) D(1,9) D(2,9) | D(1,10) D(2,10) D(1,11) D(2,11) D(1,12) D(2,12) |
| | | | |
| | | | |
| | | | |
| | | | |

MEM3

| | | |
|---|---|---|
| | | |
| | | |
| | | |
| | | |
| | | |
| | | |
| | | |
| | | |
| | | |

Sortie

Etape 3

MEM1

| | | | | | | | | | | | |
|---|---|---|---|---|---|---|---|---|---|---|---|
| D(5,1) | D(5,2) | D(5,3) | D(5,4) | D(5,5) | D(5,6) | D(5,7) | D(5,8) | D(5,9) | D(5,10) | D(5,11) | D(5,12) |
| D(6,1) | D(6,2) | D(6,3) | D(6,4) | D(6,5) | D(6,6) | D(6,7) | D(6,8) | D(6,9) | D(6,10) | D(6,11) | D(6,12) |

MEM2

| | | | |
|---|---|---|---|
| D(1,1) D(2,1) D(1,2) D(2,2) D(1,3) D(2,3) | D(1,4) D(2,4) D(1,5) D(2,5) D(1,6) D(2,6) | D(1,7) D(2,7) D(1,8) D(2,8) D(1,9) D(2,9) | D(1,10) D(2,10) D(1,11) D(2,11) D(1,12) D(2,12) |
| D(3,1) D(4,1) D(3,2) D(4,2) D(3,3) D(4,3) | D(3,4) D(4,4) D(3,5) D(4,5) D(3,6) D(4,6) | D(3,7) D(4,7) D(3,8) D(4,8) D(3,9) D(4,9) | D(3,10) D(4,10) D(3,11) D(4,11) D(3,12) D(4,12) |
| | | | |
| | | | |
| | | | |

MEM3

| | | |
|---|---|---|
| | | |
| | | |
| | | |
| | | |
| | | |
| | | |
| | | |
| | | |
| | | |

Sortie

Etape 5

MEM1

| | | | | | | | | | | | |
|---|---|---|---|---|---|---|---|---|---|---|---|
| D(9,1) | D(9,2) | D(9,3) | D(9,4) | D(9,5) | D(9,6) | D(9,7) | D(9,8) | D(9,9) | D(9,10) | D(9,11) | D(9,12) |
| D(10,1) | D(10,2) | D(10,3) | D(10,4) | D(10,5) | D(10,6) | D(10,7) | D(10,8) | D(10,9) | D(10,10) | D(10,11) | D(10,12) |

MEM2

| | | | |
|---|---|---|---|
| D(1,1) D(2,1) D(1,2) D(2,2) D(1,3) D(2,3) | D(1,4) D(2,4) D(1,5) D(2,5) D(1,6) D(2,6) | D(1,7) D(2,7) D(1,8) D(2,8) D(1,9) D(2,9) | D(1,10) D(2,10) D(1,11) D(2,11) D(1,12) D(2,12) |
| D(3,1) D(4,1) D(3,2) D(4,2) D(3,3) D(4,3) | D(3,4) D(4,4) D(3,5) D(4,5) D(3,6) D(4,6) | D(3,7) D(4,7) D(3,8) D(4,8) D(3,9) D(4,9) | D(3,10) D(4,10) D(3,11) D(4,11) D(3,12) D(4,12) |
| D(5,1) D(6,1) D(5,2) D(6,2) D(5,3) D(6,3) | D(5,4) D(6,4) D(5,5) D(6,5) D(5,6) D(6,6) | D(5,7) D(6,7) D(5,8) D(6,8) D(5,9) D(6,9) | D(5,10) D(6,10) D(5,11) D(6,11) D(5,12) D(6,12) |
| D(7,1) D(8,1) D(7,2) D(8,2) D(7,3) D(8,3) | D(7,4) D(8,4) D(7,5) D(8,5) D(7,6) D(8,6) | D(7,7) D(8,7) D(7,8) D(8,8) D(7,9) D(8,9) | D(7,10) D(8,10) D(7,11) D(8,11) D(7,12) D(8,12) |
| | | | |

MEM3

| | | |
|---|---|---|
| | | |
| | | |
| | | |
| | | |
| | | |
| | | |
| | | |
| | | |
| | | |

Sortie

Etape 6

MEM1

| | | | | | | | | | | | |
|---|---|---|---|---|---|---|---|---|---|---|---|
| | | | | | | | | | | | |
| | | | | | | | | | | | |

MEM2

| | | | | | | | | | | | | | | | | | | | | | | | |
|---|---|---|---|---|---|---|---|---|---|---|---|---|---|---|---|---|---|---|---|---|---|---|---|
| D(1,1) | D(2,1) | D(1,2) | D(2,2) | D(1,3) | D(2,3) | D(1,4) | D(2,4) | D(1,5) | D(2,5) | D(1,6) | D(2,6) | D(1,7) | D(2,7) | D(1,8) | D(2,8) | D(1,9) | D(2,9) | D(1,10) | D(2,10) | D(1,11) | D(2,11) | D(1,12) | D(2,12) |
| D(3,1) | D(4,1) | D(3,2) | D(4,2) | D(3,3) | D(4,3) | D(3,4) | D(4,4) | D(3,5) | D(4,5) | D(3,6) | D(4,6) | D(3,7) | D(4,7) | D(3,8) | D(4,8) | D(3,9) | D(4,9) | D(3,10) | D(4,10) | D(3,11) | D(4,11) | D(3,12) | D(4,12) |
| D(5,1) | D(6,1) | D(5,2) | D(6,2) | D(5,3) | D(6,3) | D(5,4) | D(6,4) | D(5,5) | D(6,5) | D(5,6) | D(6,6) | D(5,7) | D(6,7) | D(5,8) | D(6,8) | D(5,9) | D(6,9) | D(5,10) | D(6,10) | D(5,11) | D(6,11) | D(5,12) | D(6,12) |
| D(7,1) | D(8,1) | D(7,2) | D(8,2) | D(7,3) | D(8,3) | D(7,4) | D(8,4) | D(7,5) | D(8,5) | D(7,6) | D(8,6) | D(7,7) | D(8,7) | D(7,8) | D(8,8) | D(7,9) | D(8,9) | D(7,10) | D(8,10) | D(7,11) | D(8,11) | D(7,12) | D(8,12) |
| D(9,1) | D(10,1) | D(9,2) | D(10,2) | D(9,3) | D(10,3) | D(9,4) | D(10,4) | D(9,5) | D(10,5) | D(9,6) | D(10,6) | D(9,7) | D(10,7) | D(9,8) | D(10,8) | D(9,9) | D(10,9) | D(9,10) | D(10,10) | D(9,11) | D(10,11) | D(9,12) | D(10,12) |

MEM3

| | | |
|---|---|---|
| | | |
| | | |
| | | |
| | | |
| | | |
| | | |
| | | |
| | | |
| | | |

Sortie

Etape 7

MEM1

| | | | | | | | | | | | |
|---|---|---|---|---|---|---|---|---|---|---|---|
| | | | | | | | | | | | |
| | | | | | | | | | | | |

MEM2

| | | | | | | | | | | | | | | | | | | |
|---|---|---|---|---|---|---|---|---|---|---|---|---|---|---|---|---|---|---|
| | D(1,4) | D(2,4) | D(1,5) | D(2,5) | D(1,6) | D(2,6) | D(1,7) | D(2,7) | D(1,8) | D(2,8) | D(1,9) | D(2,9) | D(1,10) | D(2,10) | D(1,11) | D(2,11) | D(1,12) | D(2,12) |
| | D(3,4) | D(4,4) | D(3,5) | D(4,5) | D(3,6) | D(4,6) | D(3,7) | D(4,7) | D(3,8) | D(4,8) | D(3,9) | D(4,9) | D(3,10) | D(4,10) | D(3,11) | D(4,11) | D(3,12) | D(4,12) |
| | D(5,4) | D(6,4) | D(5,5) | D(6,5) | D(5,6) | D(6,6) | D(5,7) | D(6,7) | D(5,8) | D(6,8) | D(5,9) | D(6,9) | D(5,10) | D(6,10) | D(5,11) | D(6,11) | D(5,12) | D(6,12) |
| | D(7,4) | D(8,4) | D(7,5) | D(8,5) | D(7,6) | D(8,6) | D(7,7) | D(8,7) | D(7,8) | D(8,8) | D(7,9) | D(8,9) | D(7,10) | D(8,10) | D(7,11) | D(8,11) | D(7,12) | D(8,12) |
| | D(9,4) | D(10,4) | D(9,5) | D(10,5) | D(9,6) | D(10,6) | D(9,7) | D(10,7) | D(9,8) | D(10,8) | D(9,9) | D(10,9) | D(9,10) | D(10,10) | D(9,11) | D(10,11) | D(9,12) | D(10,12) |

MEM3

| | | |
|---|---|---|
| D(1,1) | D(1,2) | D(1,3) |
| D(2,1) | D(2,2) | D(2,3) |
| D(3,1) | D(3,2) | D(3,3) |
| D(4,1) | D(4,2) | D(4,3) |
| D(5,1) | D(5,2) | D(5,3) |
| D(6,1) | D(6,2) | D(6,3) |
| D(7,1) | D(7,2) | D(7,3) |
| D(8,1) | D(8,2) | D(8,3) |
| D(9,1) | D(9,2) | D(9,3) |
| D(10,1) | D(10,2) | D(10,3) |

Sortie

Etape 8

MEM1

| | | | | | | | | | | | |
|---|---|---|---|---|---|---|---|---|---|---|---|
| | | | | | | | | | | | |
| | | | | | | | | | | | |

MEM2

| | | | | | | | | | | | | | |
|---|---|---|---|---|---|---|---|---|---|---|---|---|---|
| | | D(1,7) | D(2,7) | D(1,8) | D(2,8) | D(1,9) | D(2,9) | D(1,10) | D(2,10) | D(1,11) | D(2,11) | D(1,12) | D(2,12) |
| | | D(3,7) | D(4,7) | D(3,8) | D(4,8) | D(3,9) | D(4,9) | D(3,10) | D(4,10) | D(3,11) | D(4,11) | D(3,12) | D(4,12) |
| | | D(5,7) | D(6,7) | D(5,8) | D(6,8) | D(5,9) | D(6,9) | D(5,10) | D(6,10) | D(5,11) | D(6,11) | D(5,12) | D(6,12) |
| | | D(7,7) | D(8,7) | D(7,8) | D(8,8) | D(7,9) | D(8,9) | D(7,10) | D(8,10) | D(7,11) | D(8,11) | D(7,12) | D(8,12) |
| | | D(9,7) | D(10,7) | D(9,8) | D(10,8) | D(9,9) | D(10,9) | D(9,10) | D(10,10) | D(9,11) | D(10,11) | D(9,12) | D(10,12) |

MEM3

| | | |
|---|---|---|
| D(1,4) | D(1,5) | D(1,6) |
| D(2,4) | D(2,5) | D(2,6) |
| D(3,4) | D(3,5) | D(3,6) |
| D(4,4) | D(4,5) | D(4,6) |
| D(5,4) | D(5,5) | D(5,6) |
| D(6,4) | D(6,5) | D(6,6) |
| D(7,4) | D(7,5) | D(7,6) |
| D(8,4) | D(8,5) | D(8,6) |
| D(9,4) | D(9,5) | D(9,6) |
| D(10,4) | D(10,5) | D(10,6) |

Sortie

| | | | | | | | | | |
|---|---|---|---|---|---|---|---|---|---|
| D(1,1) | D(2,1) | D(3,1) | D(4,1) | D(5,1) | D(6,1) | D(7,1) | D(8,1) | D(9,1) | D(10,1) |
| D(1,2) | D(2,2) | D(3,2) | D(4,2) | D(5,2) | D(6,2) | D(7,2) | D(8,2) | D(9,2) | D(10,2) |
| D(1,3) | D(2,3) | D(3,3) | D(4,3) | D(5,3) | D(6,3) | D(7,3) | D(8,3) | D(9,3) | D(10,3) |

Etape 10

MEM1

| | | | | | | | | | | | |
|---|---|---|---|---|---|---|---|---|---|---|---|
| | | | | | | | | | | | |
| | | | | | | | | | | | |

MEM2

| | | | |
|---|---|---|---|
| | | | |
| | | | |
| | | | |
| | | | |
| | | | |

MEM3

| | | |
|---|---|---|
| D(1,10) | D(1,11) | D(1,12) |
| D(2,10) | D(2,11) | D(2,12) |
| D(3,10) | D(3,11) | D(3,12) |
| D(4,10) | D(4,11) | D(4,12) |
| D(5,10) | D(5,11) | D(5,12) |
| D(6,10) | D(6,11) | D(6,12) |
| D(7,10) | D(7,11) | D(7,12) |
| D(8,10) | D(8,11) | D(8,12) |
| D(9,10) | D(9,11) | D(9,12) |
| D(10,10) | D(10,11) | D(10,12) |

Sortie

| | | | | | | | | | |
|---|---|---|---|---|---|---|---|---|---|
| D(1,7) | D(2,7) | D(3,7) | D(4,7) | D(5,7) | D(6,7) | D(7,7) | D(8,7) | D(9,7) | D(10,7) |
| D(1,8) | D(2,8) | D(3,8) | D(4,8) | D(5,8) | D(6,8) | D(7,8) | D(8,8) | D(9,8) | D(10,8) |
| D(1,9) | D(2,9) | D(3,9) | D(4,9) | D(5,9) | D(6,9) | D(7,9) | D(8,9) | D(9,9) | D(10,9) |

Etape 11

MEM1

| | | | | | | | | | | | |
|---|---|---|---|---|---|---|---|---|---|---|---|
| | | | | | | | | | | | |
| | | | | | | | | | | | |

MEM2

| | | | |
|---|---|---|---|
| | | | |
| | | | |
| | | | |
| | | | |
| | | | |

MEM3

| | | |
|---|---|---|
| | | |
| | | |
| | | |
| | | |
| | | |
| | | |
| | | |
| | | |
| | | |
| | | |

Sortie

| | | | | | | | | | |
|---|---|---|---|---|---|---|---|---|---|
| D(1,10) | D(2,10) | D(3,10) | D(4,10) | D(5,10) | D(6,10) | D(7,10) | D(8,10) | D(9,10) | D(10,10) |
| D(1,11) | D(2,11) | D(3,11) | D(4,11) | D(5,11) | D(6,11) | D(7,11) | D(8,11) | D(9,11) | D(10,11) |
| D(1,12) | D(2,12) | D(3,12) | D(4,12) | D(5,12) | D(6,12) | D(7,12) | D(8,12) | D(9,12) | D(10,12) |

Annexe 2

Etape 7

MEM1

| | | | | | | | | | | | |
|---|---|---|---|---|---|---|---|---|---|---|---|
| | | | | | | | | | | | |
| | | | | | | | | | | | |

MEM2

| | | | | | | | | | | | | | | | | | | |
|---|---|---|---|---|---|---|---|---|---|---|---|---|---|---|---|---|---|---|
| | D(1,4) | D(2,4) | D(1,5) | D(2,5) | D(1,6) | D(2,6) | D(1,7) | D(2,7) | D(1,8) | D(2,8) | D(1,9) | D(2,9) | D(1,10) | D(2,10) | D(1,11) | D(2,11) | D(1,12) | D(2,12) |
| | D(3,4) | D(4,4) | D(3,5) | D(4,5) | D(3,6) | D(4,6) | D(3,7) | D(4,7) | D(3,8) | D(4,8) | D(3,9) | D(4,9) | D(3,10) | D(4,10) | D(3,11) | D(4,11) | D(3,12) | D(4,12) |
| | D(5,4) | D(6,4) | D(5,5) | D(6,5) | D(5,6) | D(6,6) | D(5,7) | D(6,7) | D(5,8) | D(6,8) | D(5,9) | D(6,9) | D(5,10) | D(6,10) | D(5,11) | D(6,11) | D(5,12) | D(6,12) |
| | D(7,4) | D(8,4) | D(7,5) | D(8,5) | D(7,6) | D(8,6) | D(7,7) | D(8,7) | D(7,8) | D(8,8) | D(7,9) | D(8,9) | D(7,10) | D(8,10) | D(7,11) | D(8,11) | D(7,12) | D(8,12) |
| | D(9,4) | D(10,4) | D(9,5) | D(10,5) | D(9,6) | D(10,6) | D(9,7) | D(10,7) | D(9,8) | D(10,8) | D(9,9) | D(10,9) | D(9,10) | D(10,10) | D(9,11) | D(10,11) | D(9,12) | D(10,12) |

MEM3

| | | | | | | | | | |
|---|---|---|---|---|---|---|---|---|---|
| D(1,1) | D(2,1) | D(3,1) | D(4,1) | D(5,1) | D(6,1) | D(7,1) | D(8,1) | D(9,1) | D(10,1) |
| D(1,2) | D(2,2) | D(3,2) | D(4,2) | D(5,2) | D(6,2) | D(7,2) | D(8,2) | D(9,2) | D(10,2) |
| D(1,3) | D(2,3) | D(3,3) | D(4,3) | D(5,3) | D(6,3) | D(7,3) | D(8,3) | D(9,3) | D(10,3) |

Sortie

Etape 8

MEM1

| | | | | | | | | | | | |
|---|---|---|---|---|---|---|---|---|---|---|---|
| | | | | | | | | | | | |
| | | | | | | | | | | | |

MEM2

| | | | |
|---|---|---|---|
| | | D(1,7) D(2,7) D(1,8) D(2,8) D(1,9) D(2,9) | D(1,10) D(2,10) D(1,11) D(2,11) D(1,12) D(2,12) |
| | | D(3,7) D(4,7) D(3,8) D(4,8) D(3,9) D(4,9) | D(3,10) D(4,10) D(3,11) D(4,11) D(3,12) D(4,12) |
| | | D(5,7) D(6,7) D(5,8) D(6,8) D(5,9) D(6,9) | D(5,10) D(6,10) D(5,11) D(6,11) D(5,12) D(6,12) |
| | | D(7,7) D(8,7) D(7,8) D(8,8) D(7,9) D(8,9) | D(7,10) D(8,10) D(7,11) D(8,11) D(7,12) D(8,12) |
| | | D(9,7) D(10,7) D(9,8) D(10,8) D(9,9) D(10,9) | D(9,10) D(10,10) D(9,11) D(10,11) D(9,12) D(10,12) |

MEM3

| | | | | | | | | | |
|---|---|---|---|---|---|---|---|---|---|
| D(1,4) | D(2,4) | D(3,4) | D(4,4) | D(5,4) | D(6,4) | D(7,4) | D(8,4) | D(9,4) | D(10,4) |
| D(1,5) | D(2,5) | D(3,5) | D(4,5) | D(5,5) | D(6,5) | D(7,5) | D(8,5) | D(9,5) | D(10,5) |
| D(1,6) | D(2,6) | D(3,6) | D(4,6) | D(5,6) | D(6,6) | D(7,6) | D(8,6) | D(9,6) | D(10,6) |

Sortie

| | | | | | | | | | |
|---|---|---|---|---|---|---|---|---|---|
| D(1,1) | D(2,1) | D(3,1) | D(4,1) | D(5,1) | D(6,1) | D(7,1) | D(8,1) | D(9,1) | D(10,1) |
| D(1,2) | D(2,2) | D(3,2) | D(4,2) | D(5,2) | D(6,2) | D(7,2) | D(8,2) | D(9,2) | D(10,2) |
| D(1,3) | D(2,3) | D(3,3) | D(4,3) | D(5,3) | D(6,3) | D(7,3) | D(8,3) | D(9,3) | D(10,3) |

Etape 10

MEM1

| | | | | | | | | | | | |
|---|---|---|---|---|---|---|---|---|---|---|---|
| | | | | | | | | | | | |

MEM2

| | | | |
|---|---|---|---|
| | | | |
| | | | |
| | | | |
| | | | |

MEM3

| | | | | | | | | | |
|---|---|---|---|---|---|---|---|---|---|
| D(1,10) | D(2,10) | D(3,10) | D(4,10) | D(5,10) | D(6,10) | D(7,10) | D(8,10) | D(9,10) | D(10,10) |
| D(1,11) | D(2,11) | D(3,11) | D(4,11) | D(5,11) | D(6,11) | D(7,11) | D(8,11) | D(9,11) | D(10,11) |
| D(1,12) | D(2,12) | D(3,12) | D(4,12) | D(5,12) | D(6,12) | D(7,12) | D(8,12) | D(9,12) | D(10,12) |

Sortie

| | | | | | | | | | |
|---|---|---|---|---|---|---|---|---|---|
| D(1,7) | D(2,7) | D(3,7) | D(4,7) | D(5,7) | D(6,7) | D(7,7) | D(8,7) | D(9,7) | D(10,7) |
| D(1,8) | D(2,8) | D(3,8) | D(4,8) | D(5,8) | D(6,8) | D(7,8) | D(8,8) | D(9,8) | D(10,8) |
| D(1,9) | D(2,9) | D(3,9) | D(4,9) | D(5,9) | D(6,9) | D(7,9) | D(8,9) | D(9,9) | D(10,9) |

**Etape 11**

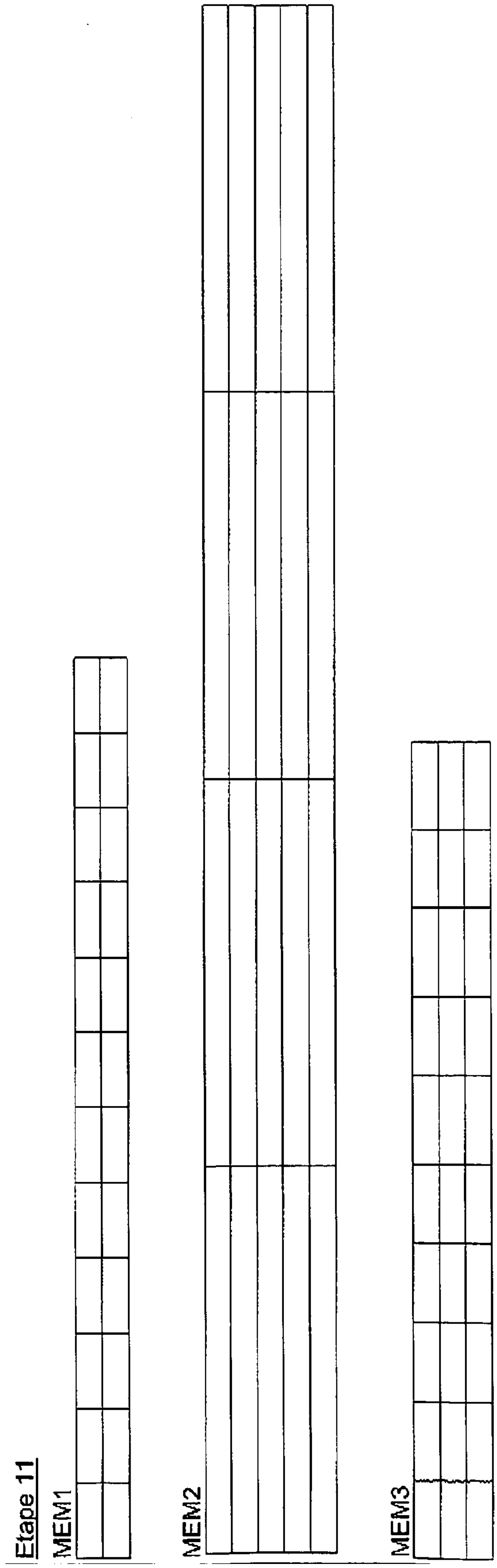


Sortie

| | | |
|---|---|---|
| D(1,10) | D(1,11) | D(1,12) |
| D(2,10) | D(2,11) | D(2,12) |
| D(3,10) | D(3,11) | D(3,12) |
| D(4,10) | D(4,11) | D(4,12) |
| D(5,10) | D(5,11) | D(5,12) |
| D(6,10) | D(6,11) | D(6,12) |
| D(7,10) | D(7,11) | D(7,12) |
| D(8,10) | D(8,11) | D(8,12) |
| D(9,10) | D(9,11) | D(9,12) |
| D(10,10) | D(10,11) | D(10,12) |

## Revendications

1. Procédé d'entrelacement d'un flux de données d'entrée réparties en blocs de données ayant chacun un nombre de lignes de données (NRB) et un nombre de colonnes de données (NCB) transversales aux lignes de données, **caractérisé en ce qu'**il comprend des étapes consistant à :

   subdiviser un bloc de données (B) en sous-blocs (M11-Mnp) ayant chacun un nombre fixe de lignes de données (NR) et un nombre fixe de colonnes de données (NC), les sous-blocs étant répartis dans le bloc en lignes de sous-blocs (i) et en colonnes de sous-blocs (j) transversales aux lignes de sous-blocs, au moins le nombre de lignes ou de colonnes des sous-blocs étant supérieur à un,
   si le nombre de lignes dans un sous-bloc est supérieur à un, transférer les données du bloc dans une première mémoire (MEM1), suivant un ordre dans lequel figurent les données dans le flux de données d'entrée,
   transférer les données du bloc, par ligne de sous-blocs, dans une seconde mémoire (MEM2) dans laquelle les données de chaque sous-bloc du bloc sont accessibles à partir d'une adresse du sous-bloc,
   si le nombre de colonnes dans un sous-bloc est supérieur à un, transférer les données de chaque sous-bloc par colonne de sous-blocs, de la seconde mémoire dans une troisième mémoire (MEM3), en replaçant les données de chaque sous-bloc en lignes et en colonnes de données dans le sous-bloc, et
   transférer les données par colonne de données du bloc de données dans un flux de sortie (IB), de la seconde mémoire si le nombre de colonnes de données dans un sous-bloc est égal à un, ou de la troisième mémoire si le nombre de colonnes de données dans un sous-bloc est supérieur à un.

2. Procédé selon la revendication 1, comprenant une étape de choix du nombre de lignes (NR) et/ou du nombre de colonnes (NC) d'un sous-bloc (M11-Mnp), de manière à ce que le nombre de lignes (NRB) et/ou le nombre de colonnes (NCB) d'un bloc de données (B) soit un multiple, respectivement du nombre de lignes et du nombre de colonnes d'un sous-bloc.

3. Procédé selon l'une des revendications 1 et 2, dans lequel les données de chaque sous-bloc (M11-Mnp) dans la seconde mémoire (MEM2) sont accédées à partir d'un numéro d'index de sous-bloc (Q) mémorisé dans une quatrième mémoire (AMA, AMB).

4. Procédé selon la revendication 3, dans lequel le nombre de lignes (NR) et le nombre de colonnes (NC) d'un sous-bloc (M11-Mnp) sont choisis de manière à limiter la taille totale des première, troisième et quatrième mémoires (MEM1, MEM3, AMA, AMB).

5. Procédé selon l'une des revendications 1 à 4, comprenant une étape de transfert de données d'une ligne de sous-blocs (i) d'un bloc suivant dans la seconde mémoire (MEM2) à des adresses occupées par des données d'une colonne (j) de sous-blocs du bloc (B), transférées dans la troisième mémoire (MEM3) ou dans le flux de sortie (IB).

6. Dispositif d'entrelacement d'un flux de données d'entrée réparties en blocs de données ayant chacun un nombre de lignes de données (NRB) et un nombre de colonnes de données (NCB) transversales aux lignes de données, **caractérisé en ce qu'**il est configuré pour mettre en oeuvre le procédé selon l'une des revendications 1 à 5.

7. Dispositif selon la revendication 6, dans lequel les blocs de données (B) reçus sont divisés en sous-blocs (M11-Mnp) ayant chacun un nombre fixe de lignes de données (NR) et un nombre fixe de colonnes de données (NC), les sous-blocs étant répartis dans le bloc en lignes de sous-blocs (i) et en colonnes de sous-blocs (j) transversales aux lignes de sous-blocs, le dispositif comprenant une première mémoire (MEM1) prévue pour recevoir une ligne (i) de sous-blocs d'un bloc de données.

8. Dispositif selon la revendication 7, dans lequel la première mémoire (MEM1) présente une capacité limitée à la taille maximum d'une ligne (i) de sous-blocs (Mi1-Mip) d'un bloc de données (B).

9. Dispositif selon l'une des revendications 6 à 8, comprenant une seconde mémoire (MEM2) prévue pour recevoir un bloc de données (B).

10. Dispositif selon la revendication 9, dans lequel la seconde mémoire (MEM2) présente une capacité limitée à la taille maximum d'un bloc de données (B).

11. Dispositif selon la revendication 9 ou 10, comprenant une quatrième mémoire (AMA, AMB) mémorisant des numéros d'index (Q), chaque numéro d'index permettant d'accéder aux données d'un sous-bloc (M11-Mnp) dans la seconde mémoire (MEM2).

**12.** Dispositif selon l'une des revendications 6 à 11, dans lequel les blocs de données (B) reçus sont divisés en sous-blocs (M11-Mnp) ayant chacun un nombre fixe de lignes de données (NR) et un nombre fixe de colonnes de données (NC), les sous-blocs étant répartis dans le bloc en lignes de sous-blocs (i) et en colonnes de sous-blocs (j) transversales aux lignes de sous-blocs, le dispositif comprenant une troisième mémoire (MEM3) prévue pour recevoir une colonne de sous-blocs d'un bloc de données.

**13.** Dispositif selon la revendication 12, dans lequel la troisième mémoire (MEM3) présente une capacité limitée à la taille maximum d'une colonne (j) de sous-blocs (M1j-Mnj) d'un bloc de données (B).

**14.** Terminal de réception de signaux comprenant un dispositif d'entrelacement selon l'une des revendications 6 à 13.

**15.** Terminal selon la revendication 14, dans lequel les signaux sont conformes au standard DVB-T2.

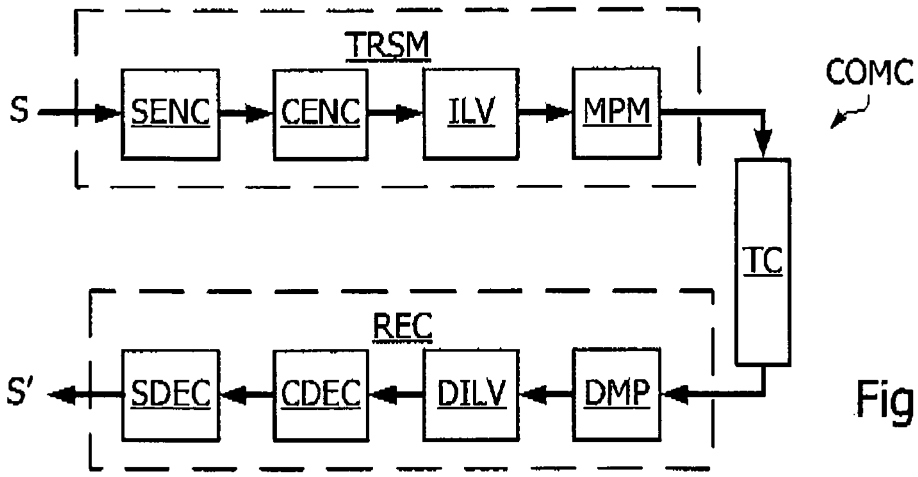


Fig. 1

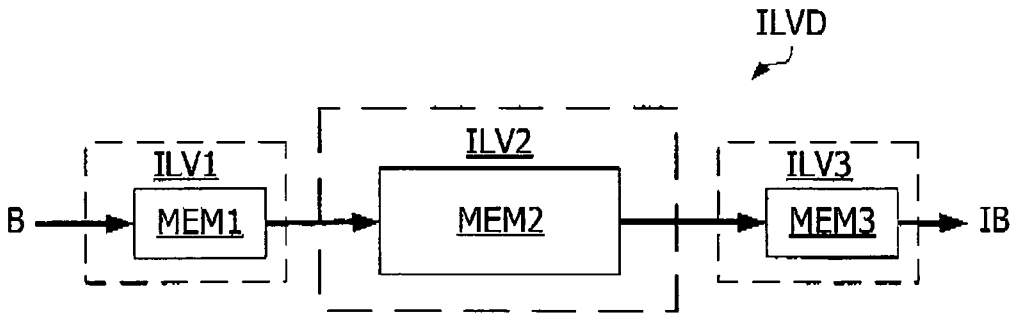


Fig. 2

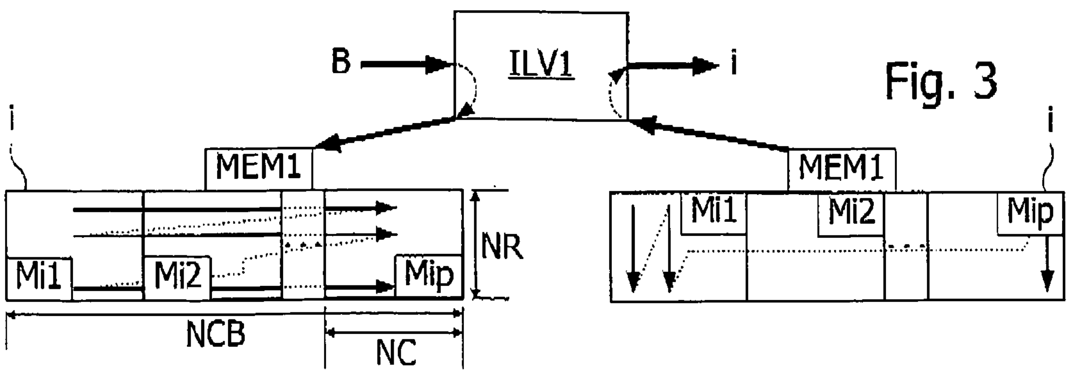


Fig. 3

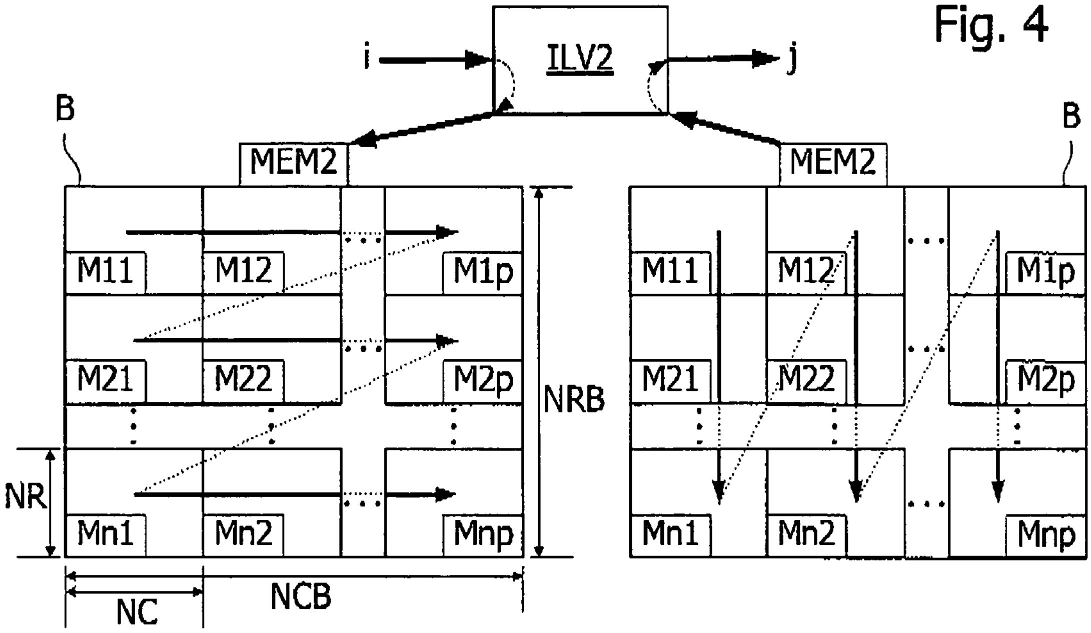
i
ILV2
j
B
MEM2
M11
M12
M1p
M21
M22
M2p
Mn1
Mn2
Mnp
NR
NRB
NC
NCB

Fig. 4

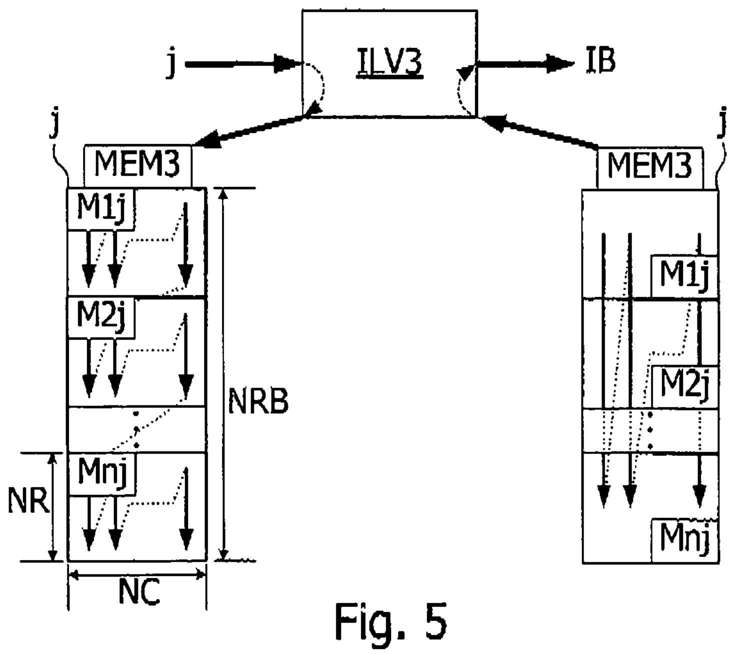
j
ILV3
IB
MEM3
M1j
M2j
Mnj
NR
NRB
NC

Fig. 5

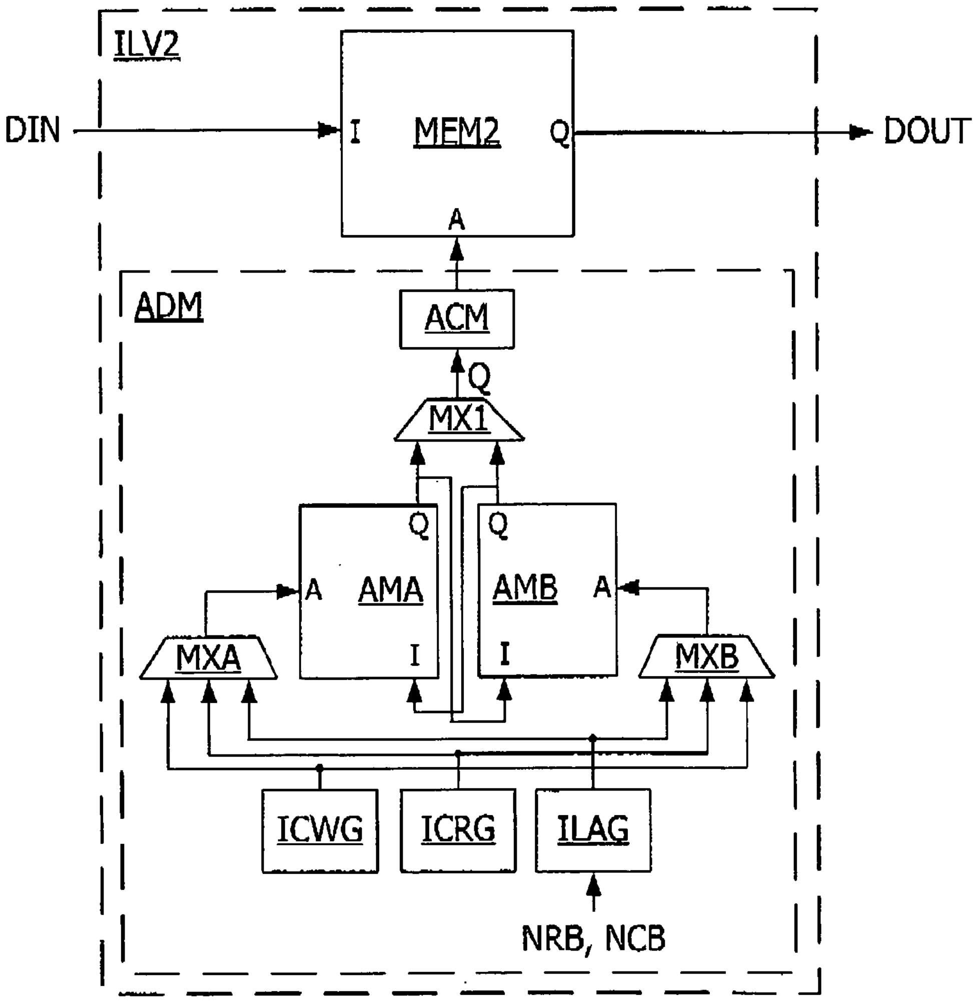
ILV2
DIN
I
MEM2
Q
DOUT
A
ADM
ACM
Q
MX1
Q
Q
AMA
AMB
A
A
I
I
MXA
MXB
ICWG
ICRG
ILAG
NRB, NCB

Fig. 6

Europäisches Patentamt
European Patent Office
Office européen des brevets

## RAPPORT DE RECHERCHE EUROPEENNE

Numéro de la demande
EP 10 01 6159

| DOCUMENTS CONSIDERES COMME PERTINENTS | | | |
|---|---|---|---|
| Catégorie | Citation du document avec indication, en cas de besoin, des parties pertinentes | Revendication concernée | CLASSEMENT DE LA DEMANDE (IPC) |
| X | Anonym: "DIGITAL VIDEO BROADCASTING (DVB); FRAME STRUCTURED CHANNEL CODING AND MODULATION FOR A SECOND GENERATION DIGITAL TERRESTRIAL TELEVISION BROADCASTING SYSTEM (dvb-T2)", ETSI Online Repository ETSI EN 302 755 V1.1.1, 31 août 2009 (2009-08-31), pages 48-55, XP002628893, Sophia Antipolis, France Extrait de l'Internet: URL:http://www.etsi.org/deliver/etsi_en/302700_302799/302755/01.01.01_60/en_302755v010101p.pdf [extrait le 2011-03-16] * le document en entier * | 1-15 | INV. H03M13/27 |
| Y | WO 2006/085251 A2 (KONINKL PHILIPS ELECTRONICS NV [NL]; VAN DEN BOSCH BRAM [BE]) 17 août 2006 (2006-08-17) * abrégé * * page 1, ligne 26 - page 2, ligne 25 * * page 7, ligne 29 - page 17, ligne 26 * | 1-15 | |
| Y | ANONYM: "FRAME STRUCTURED CHANNEL CODING AND MODULATION FOR A SECOND GENERATION DIGITAL TERRESTRIAL TELEVISION BROADCASTING SYSTEM (dvb-T2)", , 1 juin 2008 (2008-06-01), pages 32-35, XP002597610, DVB - Digital Video Broadcasting Extrait de l'Internet: URL:http://www.dvb.org/technology/dvbt2/a122.tm3980r5.DVB-T2.pdf> [extrait le 2010-08-17] * le document en entier * | 1-15 | |
| | -/-- | | |

| DOMAINES TECHNIQUES RECHERCHES (IPC) |
|---|
| H03M |
| G06F |
| H04L |
| H04N |

2

Le présent rapport a été établi pour toutes les revendications

| Lieu de la recherche | Date d'achèvement de la recherche | Examinateur |
|---|---|---|
| La Haye | 23 mars 2011 | Belardinelli, Carlo |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

Europäisches Patentamt
European Patent Office
Office européen des brevets

# RAPPORT DE RECHERCHE EUROPEENNE

Numéro de la demande
EP 10 01 6159

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | WO 02/03598 A2 (3G COM INC [US]) 10 janvier 2002 (2002-01-10)<br>* le document en entier *<br>----- | 1-15 | |
| A | GB 2 456 292 A (BRITISH BROADCASTING CORP [GB]) 15 juillet 2009 (2009-07-15)<br>* abrégé *<br>* page 7 - page 26 *<br>----- | 1-15 | |
| A | FR 2 857 178 A1 (ST MICROELECTRONICS SA [FR]) 7 janvier 2005 (2005-01-07)<br>* le document en entier *<br>----- | 1-15 | |
| A | TAKASHI YOKOKAWA ET AL: "Parity and column twist bit interleaver for DVB-T2 LDPC codes",<br>TURBO CODES AND RELATED TOPICS, 2008 5TH INTERNATIONAL SYMPOSIUM ON, IEEE, PISCATAWAY, NJ, USA,<br>1 septembre 2008 (2008-09-01), pages 123-127, XP031353674,<br>DOI: DOI:10.1109/TURBOCODING.2008.4658684<br>ISBN: 978-1-4244-2862-5<br>* alinéas [0001], [ 3.1], [ 3.2] *<br>----- | 1-15 | DOMAINES TECHNIQUES RECHERCHES (IPC) |
| A | US 2007/220406 A1 (GUBBI RAJUGOPAL [IN] ET AL GUBBI RAJUGOPAL [IN] ET AL)<br>20 septembre 2007 (2007-09-20)<br>* le document en entier *<br>----- | 1-15 | |
| A | US 2005/050284 A1 (LEE TAK K [US])<br>3 mars 2005 (2005-03-03)<br>* le document en entier *<br>----- | 1-15 | |

Le présent rapport a été établi pour toutes les revendications

2

| Lieu de la recherche | Date d'achèvement de la recherche | Examinateur |
|---|---|---|
| La Haye | 23 mars 2011 | Belardinelli, Carlo |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
..........
& : membre de la même famille, document correspondant

EPO FORM 1503 03.82 (P04C02)

## ANNEXE AU RAPPORT DE RECHERCHE EUROPEENNE RELATIF A LA DEMANDE DE BREVET EUROPEEN NO.

EP 10 01 6159

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

23-03-2011

| Document brevet cité au rapport de recherche | Date de publication | Membre(s) de la famille de brevet(s) | Date de publication |
|---|---|---|---|
| WO 2006085251 A2 | 17-08-2006 | CN 101120508 A | 06-02-2008 |
| | | EP 1851861 A2 | 07-11-2007 |
| | | JP 2008530885 T | 07-08-2008 |
| | | KR 20070102753 A | 19-10-2007 |
| | | US 2008270714 A1 | 30-10-2008 |
| WO 0203598 A2 | 10-01-2002 | AU 7314101 A | 14-01-2002 |
| | | US 6625763 B1 | 23-09-2003 |
| GB 2456292 A | 15-07-2009 | WO 2009060185 A2 | 14-05-2009 |
| FR 2857178 A1 | 07-01-2005 | US 2005050428 A1 | 03-03-2005 |
| US 2007220406 A1 | 20-09-2007 | AUCUN | |
| US 2005050284 A1 | 03-03-2005 | AUCUN | |

EPO FORM P0460

Pour tout renseignement concernant cette annexe : voir Journal Officiel de l'Office européen des brevets, No.12/82